(19) Europäisches Patentamt
European Patent Office
Office européen des brevets

(11) **EP 2 102 894 B1**

(12) **EUROPÄISCHE PATENTSCHRIFT**

(45) Veröffentlichungstag und Bekanntmachung des Hinweises auf die Patenterteilung:
**17.04.2019 Patentblatt 2019/16**

(21) Anmeldenummer: **06840969.7**

(22) Anmeldetag: **13.12.2006**

(51) Int Cl.:
**H01L 21/67** *(2006.01)*     **H01L 21/683** *(2006.01)*

(86) Internationale Anmeldenummer:
**PCT/EP2006/012005**

(87) Internationale Veröffentlichungsnummer:
**WO 2008/071211 (19.06.2008 Gazette 2008/25)**

(54) **VERFAHREN ZUM TEMPERIEREN EINES SUBSTRATS**

METHOD FOR CONTROLLING THE TEMPERATURE OF A SUBSTRATE

PROCÉDÉ DE RÉGULATION DE LA TEMPÉRATURE D'UN SUBSTRAT

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**23.09.2009 Patentblatt 2009/39**

(73) Patentinhaber: **ATT Advanced Temperature Test Systems GmbH**
**82152 Martinsried (DE)**

(72) Erfinder: **EIBL, Markus**
**81375 München (DE)**

(74) Vertreter: **Müller-Boré & Partner**
**Patentanwälte PartG mbB**
**Friedenheimer Brücke 21**
**80639 München (DE)**

(56) Entgegenhaltungen:
**EP-A- 1 005 076        EP-A- 1 473 764**
**EP-A1- 1 215 716       DE-A1-102005 014 513**
**JP-A- S 593 945        US-A- 4 566 726**
**US-A1- 2002 145 439    US-A1- 2003 077 879**

## Beschreibung

Die Erfindung betrifft ein Verfahren zum Temperieren eines Substrats und insbesondere zum Temperieren eines dünnen gebogenen bzw. gewölbten Wafers.

Zum Testen von Schaltungsanordnungen auf scheibenförmigen Substraten wie beispielsweise Halbleiterwafern, werden üblicherweise Haltevorrichtungen und insbesondere Waferchucks verwendet, die meist eine planare Auflagefläche für die scheibenförmigen Substrate aufweisen. Für eine Vielzahl von elektrischen Messungen zum Testen eines Substrats ist es notwendig, die Temperatur des Substrats auf einem konstanten, vorbestimmten Wert zu halten. Dazu werden in der Substrathaltevorrichtung Heiz- und/oder Kühlelemente ausgebildet oder die Haltevorrichtung wird mit einem herkömmlichen Thermochuck kombiniert. Um die geregelte Temperatur der Vorrichtung auch auf das Substrat zu übertragen, muß sich das Substrat in einem guten thermischen Kontakt mit der Auflagefläche der Haltevorrichtung befinden. In herkömmlichen Substrathaltevorrichtungen werden hierzu oft Vakuumöffnungen in der Anlagefläche ausgebildet, um damit ein Ansaugen des Substrats zu ermöglichen. Damit wird zum einen der thermische Kontakt zwischen Substrat und Anlagefläche verbessert, zum anderen wird dadurch ein Verrutschen des Substrats auf der Anlagefläche verhindert.

Diese herkömmlichen Thermochucks mit planaren Auflageflächen sind insbesondere für planare scheibenförmige Substrate gut geeignet. Sehr dünne Substrate und insbesondere Wafer weisen allerdings oft eine stark ausgeprägte Wölbung bzw. Durchbiegung auf, die durch mechanische Spannungen im Substrat zustande kommt. Solche Wölbungen verhindern ein planares Anlegen des Substrats an einer ebenen Anlagefläche eines Thermochucks. In herkömmlichen Thermochucks müssen solche gebogenen bzw. gewölbten Substrate zunächst an die Anlagefläche gedrückt werden, um einen großflächigen Kontakt zwischen dem Substrat und der Anlagefläche herzustellen. Anschließend kann das Substrat durch Ansaugen in Kontakt mit der Anlagefläche gehalten werden. Gebogene Substrate erfordern somit einen besonderen Arbeitsschritt, um ein Temperieren mit einem herkömmlichen Thermochuck zu ermöglichen. Der Vorgang des mechanischen Andrückens des Substrats an die Anlagefläche führt außerdem zu einer mechanischen Belastung des Substrats.

DE 10 2005 014 513 A1 offenbart eine Vorrichtung und ein Verfahren zum Temperieren eines Substrats sowie ein Verfahren zur Herstellung einer solchen Vorrichtung, welche umfasst: ein erstes Teilelement, das eine Anlagefläche zum Anliegen an das Substrat sowie eine erste Verbindungsfläche aufweist; und ein zweites Teilelement, das eine zweite Verbindungsfläche aufweist, über die es zumindest teilweise an der ersten Verbindungsfläche des ersten Teilelements anliegt, wobei zumindest eines der beiden Teilelemente Keramikmaterial umfasst, zumindest in einer der beiden Verbindungsflächen zumindest eine Ausnehmung vorgesehen ist, die zumindest einen Hohlraum in der Vorrichtung definiert, und zumindest eine erste Anschlussöffnung vorgesehen ist, über die ein Temperierfluidzu- und/oder -abfluss zu und/oder von dem zumindest einen Hohlraum ermöglicht wird.

EP 1 473 764 A2 offenbart einen Multifunktions-Substratträger sowie eine zugehörige Andockstation zur Realisierung einer lösbaren Verbindung zu einem Werkstück mit einem Trägersubstrat, einer Bernoulli-Planarisiervorrichtung zum Planarisieren des Werkstücks auf dem Trägersubstrat nach dem Bernoulli-Prinzip, einer elektrostatischen Haltevorrichtung zum Halten des Werkstücks auf dem Trägersubstrat mittels elektrostatischer Kraft und einer Vakuum-Haltevorrichtrung zum Halten des Werkstücks auf dem Trägersubstrat mittels Vakuumkraft.

Es ist eine Aufgabe der vorliegenden Erfindung, ein Verfahren zum Temperieren von Substraten und insbesondere von dünnen, gebogenen Substraten bereitzustellen, das eine einfache und für die Substrate schonende Handhabung ermöglicht.

Die Aufgabe wird gelöst durch ein Verfahren zum Temperieren eines Substrats mit den in Anspruch 1 aufgeführten Merkmalen. Bevorzugte Ausführungsformen sind Gegenstand der abhängigen Ansprüche.

Das erfindungsgemäße Verfahren zum Temperieren eines Substrats kann ausgeführt werden mit Hilfe einer Vorrichtung zum Temperieren eines Substrats, insbesondere eines Wafers, umfassend einen temperierten Hauptkörper, welcher aufweist: eine Anlagefläche zum Anliegen an das Substrat, wobei in der Anlagefläche zumindest eine Fluidaustrittsöffnung ausgebildet ist; zumindest einen Fluidzufuhranschluß, welcher vorzugsweise im wesentlichen außerhalb der Anlagefläche angeordnet ist; und zumindest einen in dem temperierten Hauptkörper ausgebildeten Fluidstromkanal, der den Fluidzufuhranschluß derart mit der zumindest einen Fluidaustrittsöffnung verbindet, dass ein über den Fluidzufuhranschluß zugeführtes und durch die Fluidaustrittsöffnung austretendes Fluid zwischen der Anlagefläche und dem Substrat einen zumindest teilweise im wesentlichen parallel zur Anlagefläche verlaufenden Fluidstrom derart erzeugt, dass sich durch die aufgrund der Fluidbewegung im Fluidstrom bewirkte Erniedrigung des statischen Drucks eine Kraft auf das Substrat mit einer im wesentlichen zur Anlagefläche hin gerichteten Kraftkomponente ausbildet.

Gemäß einem Zusammenhang zwischen Strömungsgeschwindigkeit eines Fluids und dessen statischem Druck sinkt mit steigender Strömungsgeschwindigkeit eines Fluids der statische Druck in dem Fluid. Dies gilt sowohl für Flüssigkeiten als auch für Gase.

Während im Zwischenraum zwischen dem Substrat und der Anlagefläche eine Fluidströmung auftritt, ist ein das Substrat im übrigen Bereich umgebendes Fluid vorzugsweise im wesentlichen unbewegt, d.h. es weist vorzugsweise gar keine oder höchstens eine geringe Strömungsgeschwindigkeit auf. Damit ist der statische Druck in dem umgebenden Fluid größer als im strömenden Fluid zwischen Anlagefläche und Substrat. Der erniedrigte statische Druck zwischen dem Substrat und der Anlagefläche bewirkt eine kleinere Druckkraft auf die der Anlagefläche zugewandten Flächen des Substrats als die Druckkraft, die das im wesentlichen unbewegte bzw. nicht fließende Fluid auf die der Anlagefläche nicht zugewandten Flächen des Substrats, insbesondere auf die der Anlagefläche abgewandten Flächen des Substrats, ausübt. Somit führt die Differenz im statischen Druck gemäß dem bekannten hydrodynamischen Paradoxon zu einer resultierenden Kraft auf das Substrat, die im wesentlichen in Richtung zu der Anlagefläche hin wirkt.

Vorzugsweise wird die vorliegende Vorrichtung zum Temperieren eines Substrats und insbesondere eines nicht-planaren bzw. gebogenen oder gewölbten Substrats verwendet, wobei am Fluidzufuhranschluß ein Fluid zugeführt wird, welches über den im Hauptkörper ausgebildeten Fluidstromkanal zur Anlagefläche geleitet wird, wo es durch die Fluidaustrittsöffnung wieder austritt. Das austretende Fluid erzeugt im Zwischenraum zwischen Anlagefläche und Substrat einen Fluidstrom, der eine zumindest teilweise im wesentlichen zur Anlagefläche parallele Komponente aufweist.

Zum Ausbilden des Fluidstrom umfaßt die Vorrichtung vorzugsweise eine Druckbereitstellungseinrichtung zum Bereitstellen eines Fluiddrucks am Fluidzufuhranschluß. Der Fluidzufuhranschluß ist dabei vorzugsweise in einem Bereich außerhalb der Anlagefläche angeordnet. Als Druckerzeugungseinrichtung könnte beispielsweise ein Kompressor vorgesehen sein, der mit dem Fluidzufuhranschluß in Verbindung steht. Es könnte auch eine Fluidspeichereinheit, wie z.B. ein für Flüssigkeiten besonders geeigneter höher gelegener Vorratstank oder eine unter Druck stehende Gasflasche bzw. Druckbehälters vorgesehen sein. In jedem Fall ist die Druckbereitstellungseinrichtung ausgelegt, einen Fluiddruck bereitzustellen, der über einem statischen Umgebungsdruck im Bereich des Substrats liegt.

Vorzugsweise mündet der zumindest eine Fluidstromkanal in der zumindest einen in der Anlagefläche ausgebildeten Fluidaustrittsöffnung unter einem von 0° verschiedenen Austrittswinkel zu der im Bereich der zumindest einen Fluidaustrittsöffnung zur Anlagefläche senkrechten Richtung. Damit tritt das Fluid in einer von der zur Anlagefläche senkrechten Richtung abweichenden Richtung aus der Fluidaustrittsöffnung aus. Es entsteht also direkt beim Austritt des Fluids aus dem Fluidstromkanal ein Fluidstrom mit einer zur Anlagefläche parallelen Fluß- bzw. Strömungskomponente.

Vorzugsweise liegt der Austrittswinkel, also der Winkel zwischen der zur Anlagefläche senkrechten Richtung und der Richtung, in der der zumindest eine Fluidstromkanal an der Anlagefläche mündet, im wesentlichen in einem Bereich von mehr als 30°, noch mehr bevorzugt im wesentlichen in einem Bereich zwischen 45° und 80°, am meisten bevorzugt bei etwa 60°. Somit verläuft der zumindest eine Fluidstromkanal zumindest im Bereich bzw. in der Nähe der Mündung bzw. Anlagefläche im wesentlichen entlang einer Achse, die mit der Normalen zur Anlagefläche einen Winkel einschließt, der in einem Bereich von vorzugsweise mehr als 30°, noch mehr bevorzugt im wesentlichen in einem Bereich zwischen 45° und 80°, am meisten bevorzugt bei etwa 60° liegt. Insbesondere verläuft bzw. fließt der Fluidstrom im Mündungsbereich des Fluidstromkanals im wesentlichen entlang einer solchen Achse. Damit erreicht man besonders effektiv einen Fluidstrom mit einer großen, zur Anlagefläche parallelen Flußkomponente. Es kann somit vermieden werden, dass ein auf das Substrat wirkender Staudruck durch den Fluidstrom zu einer Abstoßung des Substrats, d.h. zu einer von der Anlagefläche weg gerichteten Gesamtkraft auf das Substrat, führt. Insbesondere bei der Verwendung von kompressiblen Fluiden könnte unter Umständen bei einem sehr schnellen Einschalten des Fluidstroms, d.h. solange die Strömung im wesentlichen noch nicht stationär ist, ein entstehender Staudruck zu einer Abstoßung des Substrats führen.

In einer bevorzugten Ausführungsform verläuft der zumindest eine Fluidstromkanal zumindest bereichsweise im wesentlichen entlang einer geraden Achse. Damit werden Turbulenzen und somit Reibungsverluste im Fluid innerhalb des Fluidstromkanals verringert. Besonders bevorzugt verläuft der zumindest eine Fluidstromkanal im Bereich der Mündung an der Anlagefläche im wesentlichen entlang einer geraden Achse, was insbesondere zu einer Verringerung bzw. Vermeidung von Turbulenzen in dem sich zwischen Substrat und Anlagefläche ausbildenden Fluidstroms führt.

Vorzugsweise weist der zumindest eine Fluidstromkanal zumindest bereichsweise im wesentlichen senkrecht zur Fließrichtung des Fluids im Fluidstromkanal eine Querschnittsfläche auf, die im wesentlichen in einem Bereich zwischen $0,03$ mm$^2$ und $3$ mm$^2$, vorzugsweise zwischen $0,1$ mm$^2$ und $0,5$ mm$^2$, am meisten bevorzugt bei etwa $0,2$ mm$^2$ liegt. Besonders bevorzugt weist der zumindest eine Fluidstromkanal zumindest bereichsweise einen im wesentlichen konstanten Querschnitt auf. Die Vermeidung von Änderungen im Querschnitt des Fluidstromkanals verringert Turbulenzen und führt zu einer besonders laminaren Strömung.

Vorzugsweise liegt die Querschnittsfläche der zumindest einen Fluidaustrittsöffnung parallel zur Anlagefläche im wesentlichen in einem Bereich zwischen $0,05$ mm$^2$ und $10$ mm$^2$, vorzugsweise zwischen $0,2$ mm$^2$ und $1$ mm$^2$, am meisten bevorzugt bei ungefähr $0,34$ mm$^2$. Vorzugsweise ist der zumindest eine Fluidstromkanal zumindest bereichsweise mit einem kreisförmigen Querschnitt ausgebildet, dessen Durchmesser im wesentlichen in einem Bereich zwischen $0,2$ mm und $2$ mm, vorzugsweise zwischen $0,4$ mm und $0,8$ mm, am meisten bevorzugt im wesentlichen bei $0,5$ mm liegt. Eine besonders laminare und turbulenzarme Strömung kann dadurch ausgebildet werden, dass der zumindest eine Fluidstromkanal zumindest im Bereich der Mündung einen vorzugsweise im wesentlichen konstanten Querschnitt aufweist.

Vorzugsweise ist der Fluidstromkanal zumindest bereichsweise als Bohrung ausgestaltet. Er könnte dabei insbesondere im Bereich der Mündung in der Anlagefläche in besonders einfacher Weise als Bohrung hergestellt werden, die im Inneren des Hauptkörpers auf einen Fluiddruckkanal mit einer größeren Querschnittsfläche trifft. Somit ist der zumindest eine Fluidstromkanal vorzugsweise über zumindest einen Fluiddruckkanal mit dem Fluidzufuhranschluß verbunden, wobei der Fluiddruckkanal eine größere Querschnittsfläche aufweist als der Fluidstromkanal. Durch die größere Querschnittsfläche im Fluiddruckkanal können Reibungsverluste beim Zuführen des Fluids weiter vermindert werden. Dabei besitzt das Fluid im Fluiddruckkanal eine im Vergleich zu Fluidstromkanal niedrige Geschwindigkeit. Erst beim Eintritt in den Fluidstromkanal wird das Fluid auf die gewünschte Fluidstromgeschwindigkeit beschleunigt, wobei der statische Druck im Fluid abnimmt. Durch die kleinere Querschnittsfläche und die höhere Fließgeschwindigkeit im Fluidstromkanal treten dort höhere Reibungsverluste auf. Es ist somit besonders bevorzugt, den Fluidstromkanal als Bohrung auszubilden, die zwischen Fluiddruckkanal und Fluidaustrittsöffnung nicht länger ist als 5 mm, am meisten bevorzugt nicht länger als 2 mm.

In der am meisten bevorzugten Ausführungsform ist die Anlagefläche der Vorrichtung im wesentlichen planar, liegt also vorzugsweise im wesentlichen in einer Ebene. Damit lassen sich insbesondere planare bzw. ebene Substrate sehr leicht an der Anlagefläche anordnen und mittels der vorliegenden Vorrichtung temperieren. Vorzugsweise wird die vorliegende Vorrichtung aber auch zum Temperieren von dünnen gewölbten bzw. gebogenen Substraten verwendet. Vor allem bei der Herstellung sehr dünner Scheiben und insbesondere sehr dünner Halbleiterwafer führen mechanische Spannungen im Material des Substrats oft zu einer Wölbung der Scheiben bzw. Wafer. Dabei können die Scheiben bzw. Wafer durch Überwinden elastischer Kräfte wieder im wesentlichen in eine Ebene gebogen werden. Vorzugsweise wird die vorliegende Vorrichtung insbesondere zum Temperieren solcher Substrate verwendet, wobei die zum Biegen und damit zum Anordnen der gebogenen Substrate an der vorzugsweise planaren bzw. ebenen Anlagefläche nötigen Kräfte durch einen zwischen der Anlagefläche und dem gebogenen Substrat ausgebildeten Fluidstrom gemäß dem oben beschriebenen Prinzip aufgebracht werden.

Vorzugsweise ist im temperierten Hauptkörper eine Vielzahl von Fluidstromkanälen ausgebildet, die in einer Vielzahl von Fluidaustrittsöffnungen münden. Damit kann eine besonders effiziente Verteilung des Fluidstroms über die ganze Anlagefläche bewirkt werden.

Jeder sich zwischen der Anlagefläche und dem Substrat ausbildende Fluidstrom mit einer Flußkomponente parallel zur Anlagefläche bewirkt neben einer Kraft auf das Substrat in Richtung der Anlagefläche auch eine tangentiale Kraft parallel zur Anlagefläche bzw. parallel zu der Fläche des Substrats die der Anlagefläche zugewandt ist. Diese tangentialen bzw. parallelen Kräfte entstehen durch Reibung zwischen Fluidstrom und Substrat. Sind diese tangentialen Reibungskräfte nicht im wesentlichen symmetrisch verteilt, könnte dies zu einer resultierenden tangentialen Gesamtkraft und damit zu einer Verschiebung des Substrats parallel zur Anlagefläche und/oder zu einer Rotation des Substrats führen. Um dies zu vermeiden, sind die Fluidaustrittsöffnungen in der Vorrichtung vorzugsweise zumindest teilweise im wesentlichen ringförmig um eine Zentralachse im wesentlichen gleichmäßig verteilt, wobei jeder der Fluidstromkanäle zu der jeweiligen zumindest einen Fluidaustrittsöffnung hin in einer Richtung verläuft, die in einer Ebene mit der Zentralachse liegt und von dieser weg weist. Die Fluidaustrittsöffnungen sind dabei vorzugsweise im wesentlichen in einem Kreisring um die Zentralachse angeordnet und weisen dabei am meisten bevorzugt im wesentlichen regelmäßige oder sogar gleiche Abstände und/oder Winkelabstände auf. Die Anordnung jedes Fluidstromkanals in einer Ebene, in der auch die vorzugsweise im wesentlichen zur Anlagefläche senkrechten Zentralachse liegt, bewirkt, dass der entstehende Fluidstrom des aus den Fluidaustrittsöffnungen austretenden Fluids lediglich Strömungskomponenten in axialer Richtung, also parallel zur Zentralachse, und radialer Richtung aufweist. Insbesondere werden dadurch vorteilhaft tangentiale Strömungskomponenten im wesentlichen vermieden, die zu Rotationskräften auf das Substrat führen könnten. Die von der Zentralachse weg, also nach außen gerichtete Orientierung der Fluidstromkanäle verringert außerdem die Ausbildung eines Staudrucks, der auf das Substrat abstoßend, also von der Anlagefläche weg gerichtet, wirken könnte. Bei einer nach außen gerichteten Orientierung hingegen kann das Fluid ungehindert zur Seite, also im peripheren Bereich des Zwischenraum zwischen Substrat und Anlagefläche abfließen.

Vorzugsweise weisen zumindest diejenigen Fluidstromkanäle, welche in den Fluidaustrittsöffnungen münden, die im wesentlichen im selben Kreisring um die Zentralachse angeordneten sind, einen betragsmäßig im wesentlichen gleichen Mündungswinkel und eine im wesentlichen gleiche Querschnittsfläche auf. Durch die gleichmäßige bzw. regelmäßige Anordnung der Fluidaustrittsöffnungen im Kreisring zusammen mit den im wesentlichen gleichen Mündungswinkeln und den im wesentlichen gleichen Querschnittsflächen der Fluidstromkanäle ist es vorteilhaft möglich, eine im wesentlichen symmetrische Verteilung des Fluidstroms auszubilden. Damit können sich zur Anlagefläche bzw. zur Substratfläche im wesentlichen parallel wirkende Kräfte gegenseitig aufheben, wodurch eine Verschiebungskraft auf das Substrat parallel zur Anlagefläche vermieden wird. Besonders bevorzugt weist die Anordnung der Vielzahl von Fluidstromkanälen eine Achsen- und/oder Spiegelsymmetrie auf.

In der Vorrichtung ist im temperierten Hauptkörper zumindest ein Vakuumkanal ausgebildet, der in zumindest einer in der Anlagefläche ausgebildeten Ansaugöffnung mündet und mit einem außerhalb der Anlagefläche angeordneten Vakuumanschluß verbunden ist. Insbesondere ist der Vakuumkanal im wesentlichen röhrenförmig im Inneren des temperierten Hauptkörpers ausgebildet. Damit kann das Substrat an die Anlagefläche angesaugt und in gutem thermischen Kontakt mit der Anlagefläche gehalten werden.

Die Vorrichtung umfaßt ein Fluiddruckventil, mit dem die Fluidzufuhr und damit die Ausbildung eines Fluidstroms unterbrochen werden kann, sobald das Substrat eine vorbestimmte Annäherung an die Anlagefläche bzw. einen vorbestimmten Abstand zur Anlagefläche erreicht hat. Das Halten des Substrats an der Anlagefläche wird anschließend durch Ansaugen des Substrats über die zumindest eine Ansaugöffnung bewirkt.

Der zumindest eine Vakuumkanal mündet in zumindest einer in der Anlagefläche ausgebildeten Ansaugrille. Diese Ansaugrille ist im wesentlichen spiralförmig um eine Zentralachse angeordnet. Es könnten aber auch eine Vielzahl von Ansaugrillen ausgebildet sein, die im wesentlichen ringförmig und konzentrisch um eine Zentralachse angeordnet sind.

In einer weiteren bevorzugten Ausführungsform weist die Vorrichtung eine Heizeinrichtung auf, welche an einer der Anlagefläche im Wesentlichen gegenüberliegenden Seite des Hauptkörpers angeordnet und vom Hauptkörper durch Abschirm mittel elektrisch isoliert ist. Die Heizeinrichtung dient insbesondere der Temperierung des Substrats über eine entsprechende Temperierung des Hauptkörpers. Vorteilhafterweise ist die Heizeinrichtung eine elektrische bzw. elektronische Heizeinrichtung, wie beispielsweise eine Widerstandsheizung. Die Heizeinrichtung ist an einer im Wesentlichen der Anlagefläche gegenüberliegenden Seite des Hauptkörpers derart angeordnet, dass diese von diesem im Wesentlichen elektrisch isoliert ist. Hierfür sind vorteilhafterweise Abschirmmittel vorgesehen, welche zwischen Heizeinrichtung und Hauptkörper angeordnet sind. In einer weiteren bevorzugten Ausführungsform weist der Hauptkörper zumindest einen Sensor auf, welcher vom Hauptkörper durch Abschirmmittel elektrisch isoliert ist. Die Abschirmmittel können insbesondere entsprechend obiger Ausführung ausgebildet sein. Der Sensor kann vorteilhafterweise ein Temperatursensor sein. Es versteht sich, dass der Sensor ebenfalls jede beliebige andere Funktion erfüllen kann, beispielsweise eine Spannung oder einen Strom messen kann. Der Sensor kann vom Hauptkörper getrennt ausgebildet sein. Vorzugsweise ist der Sensor jedoch im Hauptkörper im Wesentlichen eingebettet.

Besonders vorteilhafterweise umfassen die Abschirmmittel zumindest zwei Isolationsschichten, die durch einen vorzugsweise geerdeten Schirm getrennt sind. Somit sind Schirm und Isolationsschichten besonders vorteilhafterweise sandwichartig angeordnet. Es versteht sich, dass ebenfalls mehr als zwei Isolationsschichten und/oder mehr als ein Schirm vorgesehen sein können. Die Isolationsschichten sind besonders vorteilhaft aus einem Material hoher Durchschlagsfestigkeit ausgebildet, beispielsweise Teflon oder Keramik. Der Schirm ist besonders vorteilhaft aus einem leitfähigen Material, beispielsweise Edelstahl, ausgebildet.

Durch eine derartige Vorrichtung ist es somit möglich, das Substrat, insbesondere einen Wafer, mittels sehr hoher Stromspannungen bzw. Stromstärken zu testen ohne umliegende Elemente zu beeinflussen. Infolgedessen kann die bevorzugte Vorrichtung als Hochspannungs-(Halte-)vorrichtung und/oder als Hochstrom-(Halte)vorrichtung ausgebildet sein. Hierfür weist der Hauptkörper zumindest einen Hochspannungs- und/oder Hochstrom-Anschluß auf, über welchen dem Hauptkörper eine Spannung bis etwa 8 kV zugeführt werden kann. Die das Substrat kontaktierenden Testkontakte sind hierbei entsprechend geerdet. In einem alternativen Betriebszustand kann ebenfalls eine Spannung von bis etwa 10 kV an die das Substrat kontaktierenden Testkontakte angelegt werden, wobei der Hauptkörper entsprechend geerdet ist. Es wird somit vorteilhafterweise eine Vorrichtung vorgesehen, welche bei sehr hohen Testspannungen betrieben werden kann, wobei die Heizeinrichtung vor Spannungs- und/oder Stromüberschlägen geschützt wird. Die Elektronik der Heizeinrichtung wird somit besonders vorteilhafterweise durch die Abschirmmittel vor der an dem Hauptkörper bzw. den Testkontakten anliegenden Spannung geschützt.

Im erfindungsgemäßen Verfahren wie mit Anspruch 1 definiert wird im Schritt a) des Bereitsteilens einer Vorrichtung zum Temperieren eines Substrats eine Vorrichtung wie hierin beschrieben bereitgestellt. Im Schritt b) des Annäherns des Substrats an die Anlagefläche der Vorrichtung wird das Substrat insbesondere soweit an die Anlagefläche angenähert, dass die aufgrund des Fluidstroms auf das Substrat wirkenden Kräfte ausreichen, um eine weitere Annäherung bzw. eine Anziehung des Substrats an die Anlagefläche zu bewirken. Dazu wird das Substrat vorzugsweise auf einen Abstand zur Anlagefläche angenähert, der kleiner ist als etwa 20%, noch mehr bevorzugt kleiner als etwa 5% des Durchmessers bzw. der lateralen Ausdehnung der Anlagefläche und/oder des Substrats. Am meisten bevorzugt wird im Schritt b) des Annähems des Substrats das Substrat bereits zumindest teilweise in mechanischen Kontakt mit der Anlagefläche gebracht.

Vorzugsweise wird mit dem erfindungsgemäßen Verfahren ein gewölbtes oder gebogenes insbesondere dünnes Substrat temperiert. Dazu wird das Substrat besonders bevorzugt im Schritt des Annähems an die Anlagefläche mit einer zumindest teilweise im wesentlichen konvexen Fläche derart an die Anlagefläche angenähert, dass die zumindest teilweise im wesentlichen konvexe Fläche des Substrats der Anlagefläche des Hauptkörpers zugewandt ist.

Das durch das erfindungsgemäße Verfahren temperierte Substrat ist vorzugsweise derart elastisch verformbar, dass die aufgrund des oben erwähnten Prinzips auf das Substrat wirkenden Kräfte in Richtung der Anlagefläche im wesentlichen eine Anpassung der Form des Substrats zur großflächigen Anlage an der Anlagefläche bewirken. Insbesondere wird im Schritt c) des Erzeugens einer Kraft auf das Substrat in Richtung zur Anlagefläche ein gewölbtes Substrat derart gebogen, dass es schließlich auf einer vorzugsweise planaren bzw. ebenen Anlagefläche flächig anliegt. Insbesondere beim Annähern eines gewölbten bzw. gebogenen Substrats mit einer konvexen Fläche in Richtung der Anlagefläche wird das Substrat vorzugsweise mit einem zentralen Bereich der konvexen Fläche mit der Anlagefläche in mechanischen Kontakt gebracht, bevor das vorzugsweise elastische und dünne Substrat durch die oben erwähnten Kräfte auch an den Randbereichen an die Anlagefläche gezogen bzw. gedrückt wird.

Vorzugsweise wird zum Erzeugen eines Fluidstroms durch den zumindest einen Fluidstromkanal an einem zumindest einem Fluidzufuhranschluß durch Zuführen von Fluid ein Fluiddruck bereitgestellt. Die Fließ- bzw. Strömungsgeschwindigkeit des Fluidstroms hängt dabei vom Druck ab, der am Fluidzufuhranschluß bereitgestellt wird. Dadurch kann über den bereitgestellten Fluiddruck die auf das Substrat wirkende Kraft gesteuert werden. Vorzugsweise wird der an dem zumindest einen Fluidzufuhranschluß bereitgestellte Fluiddruck in Abhängigkeit von einer Konvexität und/oder Elastizität des insbesondere gebogenen bzw. gewölbten Substrats eingestellt.

Die im Schritt a) bereitgestellte Vorrichtung weist im Hauptkörper zumindest einen Vakuumkanal auf, der in zumindest einer in der Anlagefläche ausgebildeten Ansaugöffnung mündet und mit einem außerhalb der Anlagefläche angeordneten Vakuumanschluß verbunden ist. Dabei erfolgt der Schritt d) des Haltens des Substrats in thermischem Kontakt mit der Anlagefläche durch Ansaugen des Substrats über die zumindest eine in der Anlagefläche ausgebildete Ansaugöffnung. In verschiedenen bevorzugten Ausführungsformen der Vorrichtung kann der zumindest eine Vakuumkanal entweder gesondert von dem zumindest einen Fluidstromkanal oder als ein und derselbe Kanal ausgebildet sein, der je nach Anwendung als Fluidstromkanal oder als Vakuumkanal genutzt wird. Dazu ist vorzugsweise ein Umschaltventil vorgesehen, das den Kanal (Fluidstromkanal bzw. Vakuumkanal) insbesondere je nach Ventilstellung mit dem Fluidzufuhranschluß und/oder mit dem Vakuumanschluß verbindet.

Erfindungsgemäß wird nach dem Starten des Schritts d) des Haltens des Substrats der im Schritt c) erzeugte Fluidstrom wieder unterbrochen. Nachdem das Substrat durch Ansaugen an der Anlagefläche gehalten wird, wird der Fluidstrom, der zuvor ein Annähern des Substrats an die Anlagefläche bewirkt hat, unterbrochen. Damit wird vermieden dass sich weiterhin zwischen dem Substrat und der Anlagefläche ein Fluidstrom ausbildet, der eine gute thermische Kopplung des Substrats zum Hauptkörper der Vorrichtung verhindert. Der Fluidstrom wird erst nach dem Beginn des Halteschritts unterbrochen. Damit wird vermieden, dass das Substrat sich insbesondere aufgrund elastischer Kräfte wieder von der Anlagefläche entfernt, bevor es durch Ansaugen festgehalten wird.

Weitere Vorteile und Merkmale der vorliegenden Erfindung werden mit Bezug auf die beigefügten Zeichnungen bevorzugter Ausführungsformen beispielhaft beschrieben, wobei einzelne Ausführungsformen zu neuen Ausführungsformen kombiniert werden können. Es zeigen:

Fig. 1 einen Querschnitt einer bevorzugten Ausführungsform einer Vorrichtung zum Temperieren eines Substrats.
Fig. 2 einen Querschnitt in Explosionsdarstellung sowie eine vergrößerte Querschnittsansicht entlang des Schnitts A-A einer weiteren bevorzugten Ausführungsform einer Vorrichtung zum Temperieren eines Substrats.

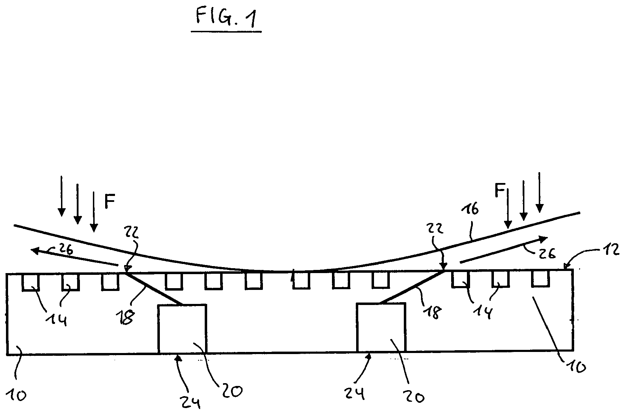

Fig. 1 zeigt einen Querschnitt einer bevorzugten Ausführungsform der Vorrichtung zum Temperieren eines Substrats (Thermochuck) und insbesondere eines Wafers. Darin weist ein Hauptkörper 10 eine im wesentlichen planare Anlagefläche 12 auf, in der eine Vielzahl von Ansaugrillen 14 ausgebildet ist. Diese Ansaugrillen 14 sind über nicht dargestellte im Inneren des Hauptkörpers ausgebildete Vakuumkanäle mit zumindest einem ebenfalls nicht gezeigten Vakuumanschluß verbunden. Über diese Ansaugrillen 14 läßt sich ein an der Anlagefläche anzuordnendes Substrat 16 zur Anlagefläche hin ansaugen und an der Anlagefläche halten. Für einen effektiven Ansaugvorgang muß das Substrat 16 allerdings vorher bereits relativ nah an die Anlagefläche angenähert werden. In dem in Fig. 1 dargestellten Fall soll ein dünnes, gewölbtes Substrat 16 und insbesondere ein dünner Wafer mit einer Durchbiegung temperiert werden. Dieses Substrat 16 wird an die Anlagefläche 12 angenähert, wobei eine konvexe Fläche des Substrats 16 der Anlagefläche 12 zugewandt ist. Für den in Fig. 1 gezeigten Fall müssen zunächst erst auch die Randbereiche des gewölbten Substrats 16 in die Nähe der Anlagefläche 12 gebracht werden, um danach ein effektives Ansaugen des Substrats 16 an die Anlagefläche 12 über die Ansaugrillen 14 zu ermöglichen.

Hierzu sind im Hauptkörper 10 der Vorrichtung Fluidstromkanäle 18 als im wesentlichen geradlinige Bohrungen mit einem Durchmesser von vorzugsweise ca. 0,6 mm ausgebildet, die sich von Druckluftkanälen 20 im Inneren des Hauptkörpers 10 zu Fluidaustrittsöffnungen 22 in der Anlagefläche 12 erstrecken. Die bevorzugt im wesentlichen geradlinig verlaufenden Achsen der Fluidstromkanäle 18, also die Achsen, entlang denen die Fluidstromkanäle 18 zumindest im Mündungsbereich im wesentlichen verlaufen, schließen dabei mit der Normalenrichtung zur Anlagefläche 12 einen Winkel von vorzugsweise ca. 60° ein. Über Fluidzufuhranschlüsse 24, die an der der Anlagefläche gegenüberliegenden Seite des Hauptkörpers ausgebildet sind, kann Fluid in die Fluiddruckkanäle 20 eingeführt werden. Das Fluid wird über die Fluidstromkanäle 18 zur Anlagefläche 12 geleitet und mündet über die Fluidaustrittsöffnungen 22 in den Zwischenraum zwischen der Anlagefläche 12 und dem Substrat 16. Insbesondere mündet das Fluid vorzugsweise unter einem Winkel von etwa 60° zur Normalenrichtung der Anlagefläche. Dort bilden sich im wesentlichen in Verlängerung zu den Richtungen der Fluidstromkanäle 18 Fluidströme 26 aus, die im wesentlichen zur Anlagefläche 12 bzw. zum Substrat 16 parallele Strömungskomponenten aufweisen.

Die Vorrichtung ist somit ausgelegt, über den Fluidzufuhranschluss 24 ein Fluid, insbesondere ein Gas, in den Fluidstromkanal 18 zuzuführen, der vorzugsweise röhrenförmig im Inneren des Hauptkörpers 10 ausgebildet ist und das zugeführte Fluid zur Fluidaustrittsöffnung 22 in der Anlagefläche 12 leitet. Das in der Vorrichtung aus der Fluidaustrittsöffnung 22 austretende Fluid bildet zwischen der Anlagefläche 12 und einem sich in der Nähe der Anlagefläche 12 befindlichen Substrat 16 einen Fluidstrom 26 aus, der zumindest teilweise im wesentlichen parallel zur Anlagefläche 12 verläuft und im peripheren Bereich der Anlagefläche 12 bzw. des Substrats 16 aus dem Zwischenraum zwischen Anlagefläche 12 und Substrat 16 austritt.

Ein Zusammenhang zwischen Strömungsgeschwindigkeit eines Fluids und dessen statischem Druck besagt, daß mit steigender Strömungsgeschwindigkeit eines Fluids der statische Druck in dem Fluid sinkt. Dieser Zusammenhang gilt sowohl für Flüssigkeiten als auch für Gase. Die vorliegende Vorrichtung läßt sich also mit beliebigen Fluiden anwenden. So ist die Ausbildung eines Gasstroms ebenso denkbar wie die Ausbildung eines Flüssigkeitsstroms. Besonders bevorzugt ist die vorliegende Vorrichtung für die Anwendung mit Druckluft ausgelegt. Es könnten aber auch andere Gase wie z.B. Stickstoff oder Edelgase eingesetzt werden.

Durch die Fluidbewegung ergibt sich je nach Art des Fluids eine Erniedrigung des statischen Drucks im Fluid. So gilt insbesondere für ideale Flüssigkeiten, d.h. für inkompressible Fluide, die Gleichung

$$p + \frac{1}{2}\rho v^2 = p_0 = const$$

Dabei ist $p$ der statische Druck in der Flüssigkeit, während $\frac{1}{2}\rho v^2$ den dynamischen Druck beschreibt, der sich aus der Dichte $\rho$ und der Strömungsgeschwindigkeit $v$ ergibt. Die Summe aus statischem und dynamischem Druck bleibt dabei stets konstant. Mit steigender Strömungsgeschwindigkeit sinkt somit der statische Druck.

Für Gase, d.h. für kompressible Fluide, muss die Änderung der Dichte $\rho$ berücksichtigt werden. Die oben genannte Gleichung kann dann in folgender Form geschrieben werden:

$$2\int_{1}^{2}\frac{dp}{\rho} + v_2^2 - v_1^2 = 0$$

Wie bei Flüssigkeiten, sinkt auch bei Gasen der stationäre Druck mit steigender Strömungsgeschwindigkeit.

Dieser Effekt bewirkt in der vorliegenden Vorrichtung, daß mit steigender Strömungsgeschwindigkeit des Fluidstroms bzw. der Fluidströme 26 zwischen Anlagefläche 12 und Substrat 16 dessen statischer Druck sinkt. Durch die Ausbildung des Fluidstroms 26 wird somit der statische Druck zwischen der Anlagefläche 12 und dem Substrat 16 gesenkt, während der statische Druck eines das Substrat 16 im übrigen Bereich umgebenden Fluids sich im wesentlichen nicht ändert.

Durch die Bewegung, also die Strömungsgeschwindigkeit, des Fluids in den Fluidströmen 26 ist der statische Druck des Fluides im Bereich der Fluidströme 26 gegenüber der Umgebung, in der das Fluid keine Strömung aufweist oder zumindest eine deutlich niedrigere Strömungsgeschwindigkeit besitzt, deutlich erniedrigt. Der dadurch entstehende Unterschied im statischen Druck oberhalb und unterhalb des Substrats, d.h. der Unterschied der Druckkräfte auf die der Anlagefläche zugewandten Flächen des Substrats und die der Anlagefläche abgewandten Flächen des Substrats, bewirkt eine effektive Gesamtkraft F auf das Substrat in Richtung der Anlagefläche. Damit wird das in Fig. 1 gezeigte gebogene Substrat insbesondere im Randbereich in Richtung der Anlagefläche gedrückt bzw. gezogen und bei ausreichender Elastizität des Substrats in Richtung der Anlagefläche bewegt.

Bei ausreichend hoher Strömungsgeschwindigkeit führt die Kraft F zu einer Verbiegung des durchgebogenen bzw. gewölbten Substrats 16 bzw. Wafers und damit zu einer vorzugsweise flächigen bzw. großflächigen, und besonders bevorzugt im wesentlichen ganzflächigen Annäherung an die Anlagefläche 12. Durch die Annäherung der Randbereiche des Substrats 16 an die Anlagefläche 12 verkleinert sich der Zwischenraum zwischen der Anlagefläche 12 und dem Substrat 16, wodurch bei konstantem Fluiddurchfluß die Strömungsgeschwindigkeit in den Fluidströmen 26 ansteigt, was zu einer weiteren Erhöhung der auf das Substrat 16 wirkenden Kraft F führt. Somit weist dieser Effekt eine selbstverstärkende Wirkung auf.

Es ist somit in der vorliegenden Vorrichtung nicht notwendig, eine zusätzliche mechanische Anordnung bereitzustellen, die ein Anordnen bzw. Andrücken des Substrats 16 an die Anlagefläche 12 der Temperiervorrichtung bewirkt. Insbesondere ist es mit der vorliegenden Vorrichtung möglich, auch bei gebogenen Substraten 16 ein flächiges bzw. großflächiges Anliegen an der Anlagefläche 12 zu erreichen. Dabei bewirkt die auf das Substrat 16 wirkende Kraft F vorteilhaft eine zumindest teilweise Anpassung der Form des Substrats 16 an die Anlagefläche 12. So können beispielsweise insbesondere dünne gebogene Wafer mittels der sich ausbildenden Kraft F in eine ebene Form gebracht und an eine ebene Anlagefläche 12 der vorliegenden Vorrichtung angeordnet werden, ohne daß dazu weitere mechanische Einrichtungen nötig wären, um das Substrat 16 in eine Ebene zu biegen.

Dies führt zu einer besonders schonenden Behandlung des Substrats 16. Vor allem läßt sich mit der vorliegenden Vorrichtung ein Fluidstom 26 zwischen dem Substrat 16 und der Anlagefläche 12 erzeugen, dessen Strömungsgeschwindigkeit einfach eingestellt (gesteuert oder geregelt) werden kann. Insbesondere können hohe Strömungsgeschwindigkeiten und damit auch hohe Anziehungskräfte F erreicht werden.

Nach ausreichender Annäherung des Substrats 16 an die Anlagefläche 12 durch die Kraft F kann das Substrat auch in den Randbereichen durch Ansaugen über die Ansaugrillen 14 an der Anlagefläche 12 gehalten werden. Vorzugsweise wird in diesem Zustand die Fluidzufuhr durch die Fluidzufuhranschlüsse 24 wieder unterbrochen, so daß kein Fluid mehr durch die Fluidaustrittsöffnungen 22 in den Zwischenraum zwischen Anlagefläche 12 und Substrat 16 austritt. Nach dem Unterbrechen der Fluidströme 26 wird das Substrat ausschließlich durch Ansaugen bzw. Unterdruck-Anlegen mittels der Ansaugrillen 14 in Anlage zur Anlagefläche 12 und damit in gutem thermischen Kontakt mit dem Hauptkörper 10 gehalten. Durch Temperieren des Hauptkörpers 10 läßt sich damit das Substrat 16 einfach und zuverlässig temperieren.

In einer anderen bevorzugten Ausführungsform sind die Vakuumkanäle und die Fluidstromkanäle 18 nicht als separate Kanäle ausgebildet sondern die Fluidstromkanäle 18 dienen gleichzeitig als Vakuumkanäle. Dabei münden die Fluidstromkanäle vorzugsweise in Vakuumrillen. Die Fluidaustrittsöffnungen sind somit vorzugsweise in den Vakuumrillen bzw. als Vakuumrillen ausgebildet.

Nachdem durch die Fluidstromkanäle 18 ein Fluid gepreßt und durch die sich ausbildenden Fluidströme 26 das Substrat 16 in die Nähe der Anlagefläche 12 gezogen bzw. gedrückt wurde, wird der Fluidfluß bzw. die Fluidströmung durch die Fluidstromkanäle 18 unterbrochen und in den Fluidstromkanälen statt dessen ein Unterdruck bzw. ein Vakuum erzeugt. Damit wird das Substrat 16 vorzugsweise noch weiter zur Anlagefläche 12 hin gezogen bzw. gesaugt, und an der Anlagefläche gehalten. Das Umschalten vom Fluidfluß zum Vakuum erfolgt dabei vorzugsweise so schnell, daß das Substrat 16 sich während dessen vorzugsweise im wesentlichen nicht oder nur sehr wenig von der Anlagefläche 12 entfernt. Vorzugsweise ist ein Umschaltventil vorgesehen, mittels dessen die Fluidstromkanäle 18 bzw. Vakuumkanäle je nach Ventilstellung mit einer Fluiddruckbereitstellungseinrichtung oder einer Vakuumbereitstellungseinrichtung verbunden werden können.

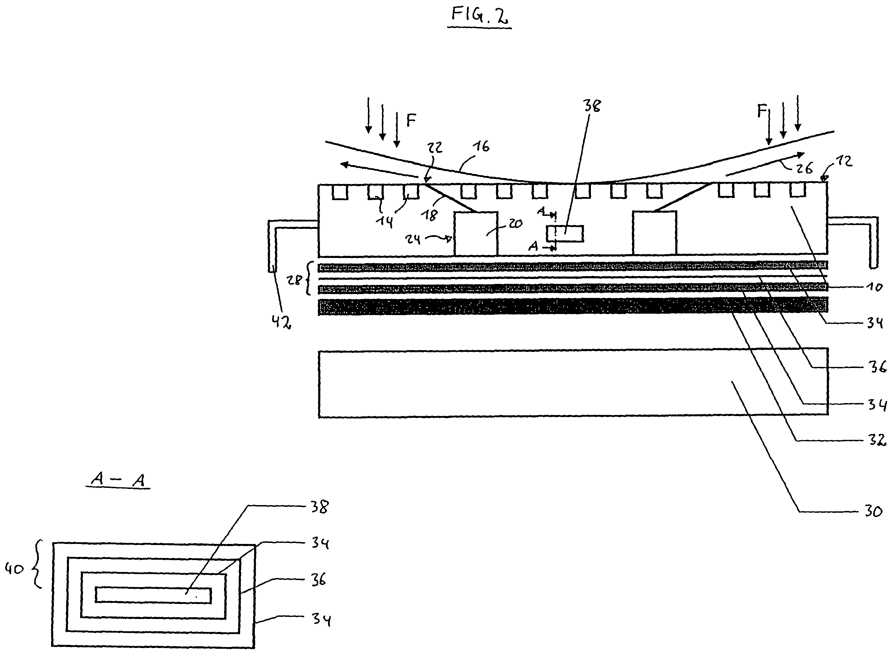

Fig. 2 zeigt einen Querschnitt einer weiteren bevorzugten Ausführungsform der Vorrichtung zum Temperieren eines Substrats (Thermochuck) und insbesondere eines Wafers. Darin ist der Hauptkörper 10 über Abschirmmittel 28 mittelbar an einer Grundplatte 30 angeordnet. An der Grundplatte 30 ist weiter vorteilhafterweise eine Heizeinrichtung 32 derart vorgesehen, daß diese ebenfalls durch die Abschirmmittel 28 von dem Hauptkörper 10 elektrisch isoliert ist. Die Heizeinrichtung 32 dient insbesondere der Temperierung des Hauptkörpers 10 und somit mittelbar ebenfalls der Temperierung des Substrats 16. Durch die Abschirmmittel 28 ist es vorteilhafterweise möglich, das am Hauptkörper 10 bzw. dessen Anlagefläche 12 anliegende Substrat 16 mit einer sehr hohen Testspannung bzw. -stromstärke zu betreiben bzw. zu testen. Hierfür weist der Hauptkörper 10 zumindest einen Hochspannungs- und/oder Hochstrom-Anschluß 42 auf, über welchen dem Hauptkörper 10 eine Spannung bis etwa 8 kV zugeführt werden kann. Es können aber auch Stromspannungen bis zu etwa 10 kV vorgesehen werden. Um die Heizeinrichtung 32 - und insbesondere deren Elektronik - vor diesen hohen Stromspannungen zu schützen, isolieren die Abschirmmittel 28 die Heizeinrichtung 32 vom Hauptkörper 10.

Die Abschirmmittel 28 sind besonders vorteilhafterweise derart ausgebildet, daß diese aus zwei Isolationsschichten 34 ausgebildet sind, die durch einen vorzugsweise geerdeten Schirm 36 getrennt sind. Die Isolationsschichten 34 weisen vorteilhafterweise eine Durchschlagsfestigkeit von etwa 10 kV auf. Weiterhin bevorzugterweise kann die Vorrichtung zusätzlich einen Sensor 38 aufweisen, der im Hauptkörper 10 eingebettet ist. Der Sensor 38 kann beispielsweise die Temperatur, Stromspannung oder Stromstärke messen. Es versteht sich, daß der Sensor 38 ebenfalls weitere oder alternative Parameter erfassen kann. Um den Sensor 38 vor einer am Hauptkörper 10 anliegenden elektrischen Spannung zu schützen, ist dieser vorteilhafterweise ebenfalls durch Abschirmmittel 40 von Hauptkörper 10 elektrisch isoliert. Die Abschirmmittel 40 weisen - wie oben dargestellt - zumindest zwei Isolationsschichten 34 auf, die durch einen vorzugsweise geerdeten Schirm 36 getrennt sind.

Hierdurch wird ein besonders vorteilhafter Schutz der Elektronik der Heizeinrichtung 32 bzw. des Sensors 38 gewährleistet, so daß die Vorrichtung als Hochspannungs- und/oder Hochstrom-Chuck-System bzw. -vorrichtung eingesetzt werden kann.

**Bezugszeichenliste**

10    Hauptkörper

12    Anlagefläche
14    Ansaugrillen
16    Substrat
18    Fluidstromkanal
20    Fluiddruckkanal
22    Fluidaustrittsöffnungen
24    Fluidzufuhranschlüsse
26    Fluidströme
28    Abschirmmittel
30    Grundplatte
32    Heizeinrichtung
34    Isolationsschichten
36    Schirm
38    Sensor
40    Abschirmmittel
42    Hochspannungs- und/oder Hochstrom-Anschluß
F     Kraft

**Patentansprüche**

1.  Verfahren zum Temperieren eines Substrats (16) umfassend die Schritte:

    a) Bereitstellen einer Vorrichtung zum Temperieren eines Substrats (16) umfassend einen Hauptkörper (10) mit einer Anlagefläche (12) und zumindest einem Vakuumkanal, der in zumindest einer in der Anlagefläche (12) ausgebildeten Ansaugöffnung mündet und mit einem außerhalb der Anlagefläche (12) angeordneten Vakuumanschluss verbunden ist;
    b) Annähern des Substrats (16) an die Anlagefläche (12) der Vorrichtung;
    c) Erzeugen einer Kraft (F) auf das Substrat (16) in Richtung zur Anlagefläche (12) hin durch Erzeugen eines Fluidstroms (26) zwischen dem Substrat (16) und der Anlagefläche (12);
    d) Halten des Substrats (16) in thermischem Kontakt mit der Anlagefläche (12) durch Ansaugen des Substrats (16) über die zumindest eine in der Anlagefläche (12) ausgebildete Ansaugöffnung; und
    e) Temperieren des über die Anlagefläche (12) mit der Vorrichtung in thermischem Kontakt stehenden Substrats (16) durch Temperieren des Hauptkörpers (10) der Vorrichtung,

    **dadurch gekennzeichnet, dass**
    die zumindest eine Ansaugöffnung eine Ansaugrille (14) ist, wobei die zumindest eine Ansaugrille (14) im wesentlichen spiralförmig oder ringförmig und konzentrisch um eine Zentralachse angeordnet ist, und dass
    nach dem Starten des Schritts d) des Haltens des Substrats (16) der im Schritt c) erzeugte Fluidstrom (26) unterbrochen wird.

2.  Verfahren nach Anspruch 1, wobei der Schritt d) des Haltens des Substrats (16) in thermischem Kontakt mit der Anlagefläche (12) nach dem Schritt c) des Erzeugens einer Kraft (F) auf das Substrat (16) erfolgt.

3.  Verfahren nach einem der vorhergehenden Ansprüche, wobei im Schritt b) des Annäherns des Substrats (16) an die Anlagefläche (12) ein Substrat (16) mit einer zumindest teilweise im wesentlichen konvexen Fläche derart an die Anlagefläche (12) angenähert wird, dass die zumindest teilweise im wesentlichen konvexe Fläche des Substrats (16) der Anlagefläche (12) des Hauptkörpers (10) zugewandt ist.

4.  Verfahren nach einem der vorhergehenden Ansprüche, wobei im Schritt b) des Annäherns des Substrats (16) an die Anlagefläche (12) das Substrat (16) mit der Anlagefläche (12) in mechanischen Kontakt gebracht wird.

5.  Verfahren nach einem der vorhergehenden Ansprüche, wobei im Schritt c) zum Erzeugen des Fluidstroms (26) zwischen dem Substrat (16) und der Anlagefläche (12) an einem zumindest einem Fluidzufuhranschluss (24) durch Zuführen von Fluid ein Fluiddruck bereitgestellt wird.

6.  Verfahren nach Anspruch 5, wobei der an dem zu- mindest einen Fluidzufuhranschluss (24) bereitge- stellte Fluiddruck in Abhängigkeit von einer Konvexität und/oder Elastizität des Substrats (16) festgelegt wird.

**Claims**

1.  A method for controlling the temperature of a substrate (16), comprising the steps of:

    a) providing a device for controlling the temperature of a substrate (16), comprising a main body (10) having a contact surface (12) and at least one vacuum channel, which leads into at least one suction opening formed in the contact surface (12) and which is connected to a vacuum port arranged outside the contact surface (12);
    b) bringing the substrate (16) closer to the contact surface (12) of the device;
    c) generating a force (F) on the substrate (16) in the direction of the contact surface (12) by generating a fluid flow (26) between the substrate (16) and the contact surface (12);
    d) holding the substrate (16) in thermal contact with the contact surface (12) by drawing in the substrate (16) via the at least one suction opening formed in the contact surface (12); and
    e) controlling the temperature of the substrate (16) that is in thermal contact with the device via the contact surface (12) by controlling the temperature of the main body (10) of the device,

**characterized in that**
the at least one suction opening is a suction groove (14), the at least one suction groove (14) being arranged around a central axis in a substantially helical or annular and concentric manner, and **in that** the fluid flow (26) generated in step c) is interrupted once step d), the step of holding the substrate (16), has begun.

2. The method according to claim 1, wherein step d), the step of holding the substrate (16) in thermal contact with the contact surface (12), follows step c), the step of generating a force (F) on the substrate (16).

3. The method according to either of the preceding claims, wherein during step b), the step of bringing the substrate (16) closer to the contact surface (12), a substrate (16) having an at least partially substantially convex surface is brought closer to the contact surface (12) in such a way that the at least partially substantially convex surface of the substrate (16) is facing the contact surface (12) of the main body (10).

4. The method according to any one of the preceding claims, wherein during step b), the step of bringing the substrate (16) closer to the contact surface (12), the substrate (16) is brought into mechanical contact with the contact surface (12).

5. The method according to any one of the preceding claims, wherein during step c), in order to generate the fluid flow (26) between the substrate (16) and the contact surface (12), a fluid pressure is applied to at least one fluid inlet port (24) by feeding in fluid.

6. The method according to claim 5, wherein the fluid pressure applied to the at least one fluid inlet port (24) is set depending on a convexity and/or resilience of the substrate (16).

**Revendications**

1. Procédé de régulation de la température d'un substrat (16) comprenant les étapes suivantes :

a) Préparation d'un dispositif de régulation de la température d'un substrat (16) comportant un corps principal (10) avec une surface d'appui (12) et au moins un canal à vide, qui débouche dans au moins un orifice d'aspiration formé dans la surface d'appui (12) et qui est relié à un raccord au vide disposé en dehors de la surface d'appui (12) ;

b) Rapprochement du substrat (16) contre la surface d'appui (12) du dispositif ;
c) Création d'une force (F) sur le substrat (16) en direction de la surface d'appui (12) par la production d'un flux de fluide (26) entre le substrat (16) et la surface d'appui (12) ;
d) Maintien du substrat (16) en contact thermique avec la surface d'appui (12) par l'aspiration du substrat (16) via au moins ledit orifice d'aspiration formé dans la surface d'appui (12) ; et
e) Régulation de la température du substrat (16) se trouvant en contact thermique avec le dispositif au moyen de la surface d'appui (12) par la régulation de la température du corps principal (10) du dispositif,

**caractérisé en ce que**
ledit orifice d'aspiration au moins est une rainure d'aspiration (14),
dans lequel ladite rainure d'aspiration (14) au moins est disposée essentiellement sous une forme spiralée ou annulaire et concentrique autour d'un axe central, et que
le flux de fluide (26) généré au cours de l'étape c) est interrompu après le démarrage de l'étape d) du maintien du substrat (16).

2. Procédé selon la revendication 1, dans lequel l'étape d) du maintien du substrat (16) en contact thermique avec la surface d'appui (12) se déroule après l'étape c) de création d'une force (F) sur le substrat (16).

3. Procédé selon l'une des revendications précédentes, dans lequel un substrat (16) présentant une surface principalement convexe du moins en partie est rapproché de la surface d'appui (12) au cours de l'étape b) du rapprochement du substrat (16) contre la surface d'appui (12) de telle façon que la surface du substrat (16) principalement convexe du moins en partie est tournée vers la surface d'appui (12) du corps principal (10).

4. Procédé selon l'une des revendications précédentes, dans lequel le substrat (16) est mis en contact mécanique avec la surface d'appui (12) au cours de l'étape b) du rapprochement du substrat (16) contre la surface d'appui (12).

5. Procédé selon l'une des revendications précédentes, dans lequel une pression de fluide est fournie par l'apport d'un fluide au niveau au moins d'un raccord d'alimentation en fluide (24) au cours de l'étape c) servant à la production du flux de fluide (26) entre le substrat (16) et la surface d'appui (12).

6. Procédé selon la revendication 5, dans lequel la pression de fluide fournie au niveau au moins dudit raccord d'alimentation en fluide (24) est établie en fonction d'une convexité et/ou d'une élasticité du substrat (16).

FIG. 1

FIG. 2

EP 2 102 894 B1

A - A

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005014513 A1
- EP 1473764 A2